# EUROPÄISCHE PATENTANMELDUNG

(11) **EP 4 414 720 A1**
(43) Veröffentlichungstag der Anmeldung: **14.08.2024**
(21) Anmeldenummer: 24156089.5
(22) Anmeldetag: 06.02.2024
(51) Int. Cl.: G01R 19/10, G01R 19/155, G01R 29/18, G01R 19/25, G01R 25/00

(54) **PHASENVERGLEICHERSCHALTUNG**

(30) Priorität: 08.02.2023 DE 102023103069
(71) Anmelder: H. Horstmann GmbH, 42579 Heiligenhaus (DE)
(72) Erfinder: Würsig, Holger, 47239 Duisburg (DE)
(74) Vertreter: Taruttis, Tilman

(57) **Zusammenfassung**

Es wird eine Schaltung eines Phasenvergleichers zur Anzeige einer jeweiligen Spannung sowie einer Phasendifferenz der Messspannung von zwei Leitern beschrieben, wobei ein erster und ein zweiter passiver Messkanal die Leiter auf Spannung prüfen. Ein Phasendifferenzdetektor steuert ein Phasendifferenzsymbol an, falls eine Phasendifferenz zwischen den Messspannungen ermittelt wird.

## Beschreibung

Die vorliegende Erfindung betrifft eine passive Phasenvergleicherschaltung mit einer Prüfung auf Spannungsfreiheit für Spannungsprüfsysteme in der Mittel- bis Höchstspannung.

Der hier beschriebene Phasenvergleicher ist insbesondere für genormte Spannungsprüfsysteme vorgesehen, die typischerweise in Hochspannungsschaltanlagen eingebaut sind und den Spannungszustand feststellen und anzeigen, typischerweise für Spannungssystem mit Spannungen von mehr als 1000 Volt.

Ein Phasenvergleicher ermittelt eine Phasendifferenz zwischen Wechselspannungen von zwei Leitern. Dabei wird unterschieden in Phasengleichheit oder Phasenungleichheit. Insbesondere in der Hochspannungstechnik, z. B. in Schaltanlagen, wird die Phasenungleichheit beziehungsweise die Abweichung von einem vorgegebenen Phasendifferenzsollwert und Spannung durch Prüfgeräte überwacht und angezeigt. Dabei ist sicherzustellen, dass an beiden Leitern eine Wechselspannung gegenüber Erdpotential anliegt.

Hieraus ergibt sich die notwendige Anforderung an diese Prüfgeräte, dass zur Spannungsprüfung und Phasenvergleich von spannungsführenden Leitern das Vorhandensein der Spannung auf beiden Messkanälen festzustellen ist.

In der Literatur und auf dem Markt sind entsprechende Prüfgeräte erhältlich, die diese Anforderungen erfüllen. Die Prüfgeräte sind oft als multifunktionale Geräte ausgeführt, die neben dem Phasenvergleich auch weitere Funktionen wie Spannungsprüfung und Wiederholungsprüfung enthalten. Typischerweise weisen diese Geräte unter anderem Prozessoren und digitale Bauteile in den Messketten und zur Steuerung der Anzeige auf. Eine Verwendung dieser Komponenten erfordert jedoch eine stabile Energieversorgung. Insbesondere eine interne Energieversorgung der Prozessoren und Anzeige durch z.B. Batterien geht mit dem Nachteil einher, dass dies zu weiteren Anforderungen an die Elektronik führt, wie z. B. Selbsttest, die den Umfang und den Prüfaufwand der Prüfgeräte selbst weiter erschweren.

Aufgabe der vorliegenden Erfindung ist es daher, eine Schaltung für einen Phasenvergleicher bereit zu stellen, der auch das Erfordernis der vorherigen Prüfung auf Spannungsfreiheit erfüllt und der keine Energieversorgungsquelle benötigt.

Diese Aufgabe wird gelöst durch eine Schaltung mit den Merkmalen des unabhängigen Anspruchs 1. Weitere vorteilhafte Ausgestaltungen der Erfindung sind in den abhängig formulierten Ansprüchen angegeben. Die in den abhängig formulierten Ansprüchen einzeln aufgeführten Merkmale sind in technologisch sinnvoller Weise miteinander kombinierbar und können weitere Ausgestaltungen der Erfindung definieren.

Erfindungsgemäß wird eine Schaltung eines passiven Phasenvergleichers mit passiver Prüfung auf das Vorhandensein von Spannung beziehungsweise Spannungsfreiheit der beiden Leiter und einer passiven Ermittlung einer Phasendifferenz beschrieben, wobei jeweilige passive Anzeigeelemente zur Anzeige der Spannungsprüfungsergebnisse sowie einer Phasendifferenz vorgesehen sind. Dabei bedeutet passiv jeweils, dass kein verwendetes Element der Schaltung eine Energieversorgung benötigt. Für das Ermitteln der Spannungsfreiheit der Leiter und der entsprechenden Anzeige sowie zur Ermittlung einer Phasendifferenz sowie zur Anzeige der ermittelten Phasendifferenz benötigt die Schaltung dementsprechend weder einen Energiespeicher noch einen Energieabgriff, beispielsweise von den Leitern, um eine Versorgungsenergie bereit zu stellen.

Die Schaltung dieses Phasenvergleichers umfasst einen ersten und einen zweiten Messkanal, die jeweils nur passive elektrische Bauelemente aufweisen. Ein jeweiliger Messkanal weist einen Spannungsdetektor zur Erzeugung eines Spannungsanzeigesignals auf, wobei als Bezugspotential Erdpotential angenommen wird. Der erste sowie der zweite Messkanal ist mit einem ersten Spannungsanzeigeelement zur Anzeige eines jeweiligen Spannungsanzeigesignals verbunden, sodass die Spannungsfreiheit bzw. das Führen von Spannung des jeweiligen Leiters angezeigt wird, wenn die Spannung größer als ein Schwellwert ist.

Der Ausgang des ersten sowie des zweiten Messkanals ist auch jeweils mit einem Eingang eines Phasendifferenzsignaldetektors verbunden, sodass das erste und das zweite Spannungsanzeigesignal dem Phasendifferenzsignaldetektor jeweils als Eingangssignal zugeführt werden. Basierend auf dem ersten und zweiten Spannungsanzeigesignal liefert der Phasendifferenzdetektor ein Phasendifferenzsignal, welches ein Phasendifferenzanzeigeelement ansteuert, sodass dieses bei Vorliegen einer Phasendifferenz ein entsprechendes Symbol anzeigt.

Das erste sowie das zweite Spannungsanzeigeelement sowie das Phasenvergleichsanzeigeelement sind in einer bevorzugten Ausführungsform jeweils eine passive Anzeige, insbesondere eine passive LCD-Anzeige. Eine passive Anzeige benötigt neben den Steuersignalen keine Energieversorgung zur Versorgung der Anzeige, sodass das jeweilige anzuzeigende Signal entsprechend angezeigt wird. Bei einer passiven LCD-Anzeige reicht hier allein die Energie des jeweils anzuzeigenden Signals aus, um das Anzeigeelement entsprechend so zu steuern, dass ein Symbol angezeigt wird. Die LCD- Anzeige kann dazu eine lichtreflektierende Schicht aufweisen, sodass das LCD transflektiv ist.

In einer Ausführungsform der Schaltung liegt am ersten Leiter und/ oder am zweiten Leiter zum jeweiligen Bezugspotential, bevorzugt Erde, eine vom in der Hochspannungsschaltanlage befindlichen und mit dem Phasenvergleicher verbundenen Spannungsprüfsystem gelieferten Wechselspannung vor, wobei vorausgesetzt wird, dass die Spannungsamplituden innerhalb der von den einschlägigen Normen festgelegten Grenzen gleich sind, wenn beide Leiter Spannung führen.

Die Erfindung sowie das technische Umfeld werden nachfolgend anhand der Figuren näher erläutert. Es ist darauf hinzuweisen, dass die Erfindung durch die gezeigten Ausführungsbeispiele nicht beschränkt werden soll. Gleiche Bezugszeichen bezeichnen gleiche Gegenstände, so dass ggf. Erläuterungen aus anderen Figuren ergänzend herangezogen werden können. Es zeigen:
- Fig. 1:: eine Schaltung einer ersten Ausgestaltung eines erfindungsgemäßen Phasenvergleichers,
- Fig. 2:: eine Detailansicht eines Messkanals mit Spannungsanzeigeelement
- Fig. 3:: eine Detailansicht Phasendifferenzdetektors mit einem Phasendifferenzanzeigeelement
- Fig. 4:: eine Schaltung einer zweiten Ausgestaltung eines erfindungsgemäßen Phasenvergleichers

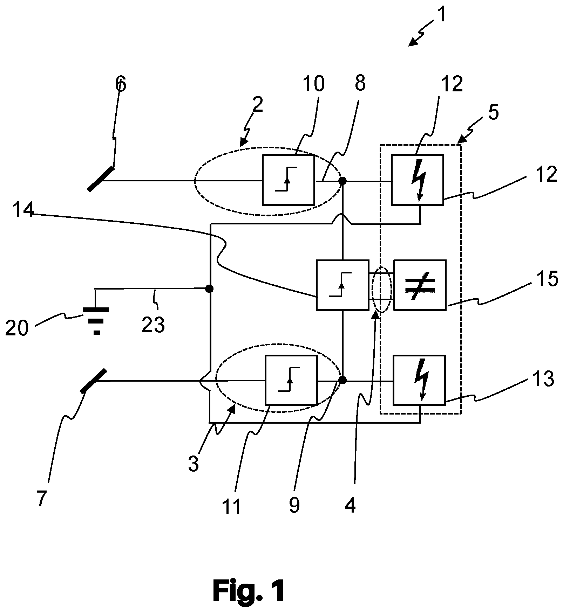

Fig. 1 zeigt eine schematische Darstellung einer Phasenvergleicherschaltung 1, die einen ersten Messkanal 2 zum Ankoppeln an einen ersten Leiter 6, einen zweiten Messkanal 3 zum Ankoppeln an einen zweiten Leiter 7 und einen Erdleiter 23 zur Verbindung mit einem Bezugspotential 20, hier bevorzugt Erdpotential, aufweist. Der erste Leiter 6 führt typischerweise eine erste Messspannung, der zweite Leiter 7 entsprechend eine zweite Messspannung, zwischen denen eine Phasendifferenz ermittelt und gegebenenfalls angezeigt wird. Die Messspannung ist dabei eine heruntergeteilte Spannung, die typischerweise von einem Spannungsprüfsystem erzeugt wird und die dazu typischerweise einen Spannungsteiler aufweist, um die Spannung der Leiter beispielsweise eines Energieversorgungssystems mit Spannungen von mehr als 1000 Volt herunter zu teilen.

Der erste Messkanal 2 sowie der zweite Messkanal 3 umfassen bevorzugt gleiche elektrische Bauelemente und sind damit bevorzugt identisch aufgebaut, sodass sich diese hinsichtlich einer Phasenverschiebung gleich verhalten und keine oder eine gleiche Verschiebung der Phasen der erzeugten Spannungsanzeigesignale bezüglich der Messspannung des ersten und des zweiten Leiters 6, 7 bewirken.

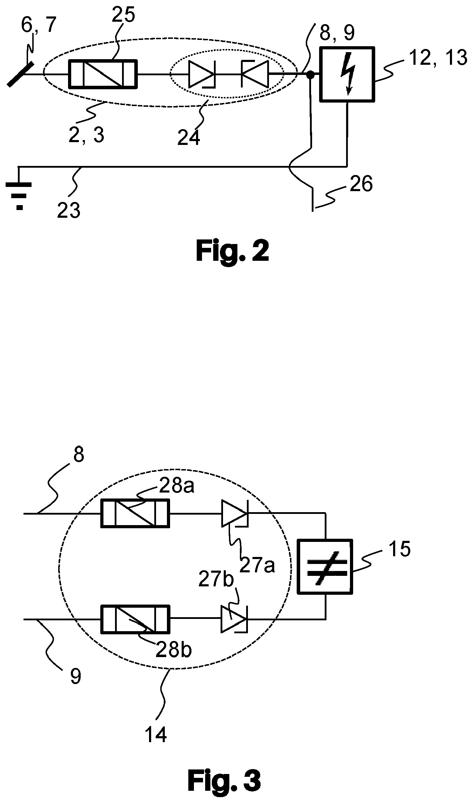

Figur 2 zeigt eine schematische Abbildung eines ersten oder zweiten Messkanals 2, 3, der an einen Messspannung führenden Leiter 6 oder 7 gekoppelt ist. Der Messkanal umfasst zwei antiseriell geschaltete Zener- bzw. Avalanchedioden, hier gemeinsam mit 24 bezeichnet, wobei nachfolgend der Begriff Zenerdiode verwendet wird. Antiseriell bedeutet, dass die Zenerdioden in Reihe geschaltet und in ihrer Durchlassrichtung gegeneinander gerichtet sind. Die beiden antiseriellen Zenerdioden bilden damit einen Spannungsdetektor, der ein Spannungsanzeigesignal 8, 9 erzeugt, wenn der Betrag der Eingangsspannung dem Betrag nach größer als ein Schwellwert ist. Die Höhe des Schwellwerts richtet sich dabei nach den Halbleitereigenschaften der Zenerdioden. Ist die Messspannung dem Betrag nach größer als der spezifische Schwellwert der Zenerdioden des Schwellwertdetektors, so ist das Ausgangssignal, hier also das Spannungsanzeigesignal 8 oder 9, dem Betrag nach größer Null. Die Polarität des Spannungsanzeigesignals entspricht dabei derjenigen der jeweilig anliegenden Messspannung.

In einer Ausführungsform kann ein Messkanal eine Impedanz 25 aufweisen, wobei der Spannungsdetektor 10 bzw. 11 vorzugsweise über die Impedanz 25 mit dem Messspannung führenden ersten oder zweiten Leiter, 6 - 7, verbunden ist. Dabei kann die Impedanz 25 vorzugsweise eine Kapazitanz umfassen. In einer weiteren Ausführungsform kann die Impedanz 25 eine Induktivität (Spule) umfassen oder einen Ohm'schen Widerstand aufweisen.

Der Ausgang eines Messkanals 2 bzw. 3 ist zum einen mit einem jeweiligen Spannungsanzeigeelement 12, 13 verbunden, welches ein Symbol für eine Spannung anzeigt, falls das Spannungsanzeigesignal 8, 9 ungleich Null ist. Das Spannungsanzeigeelement ist dabei über einen Erdleiter 23 mit dem Bezugspotential verbunden.

Zum anderen ist der Ausgang des jeweiligen Messkanals 2 bzw. über eine jeweilige Leitung 26 mit einem jeweiligen Eingang eines Phasendifferenzdetektors 14 verbunden, sodass das Spannungsanzeigesignal eines jeweiligen Spannungsdetektors als Eingang an einen Phasendifferenzdetektor 14 zur weiteren Auswertung geleitet wird.

Fig. 1 zeigt weiterhin, dass die Phasenvergleicherschaltung 1 einen Phasendifferenzdetektor 14 umfasst, dessen Eingang die Spannungsanzeigesignale 8, 9 erhält. Ist die Messspannung des jeweiligen Leiters kleiner als die Schwellwertspannung des Schwellwertdetektors, so ist das Spannungsanzeigesignal gleich Null. Sobald die Messspannung die Schwellwertspannung übersteigt, leitet der Spannungsdetektor die anliegende Eingangsspannung reduziert um den Spannungsschwellwert durch, sodass das Spannungsanzeigesignal ebenfalls eine Wechselspannung ist. Die Phasen des ersten sowie des zweiten Spannungsanzeigesignals folgen dabei der Phase der Messspannung des jeweiligen Leiters.

Die Messkanäle 2, 3 weisen gleiche elektrische Bauelemente auf. Eine Phasendifferenz zwischen den Messspannungen in den Spannungsanzeigesignalen 8, 9 bleibt damit erhalten, weil die Messkanäle 2, 3 aufgrund ihres identischen Aufbaus dieselbe Phasenverschiebung bewirken.

Figur 3 zeigt schematisch einen Aufbau eines Phasendifferenzdetektors 14, der zur Anzeige einer Phasendifferenz mit einem Phasendifferenzanzeigeelement 15 verbunden ist. Der Phasendifferenzdetektor 14 wertet die verkettete Spannung zwischen dem ersten und zweiten Spannungsanzeigesignal 8, 9 aus. Sind die Messspannungen des ersten und zweiten Leiters 6, 7 in Phase, so sind die von den Messkanälen 2, 3 ausgegebenen Spannungsanzeigesignale 8, 9 ebenfalls in Phase, sodass die verkettete Spannung gleich Null ist. Falls die Spannungsanzeigesignale 8, 9 eine Phasendifferenz aufweisen, so ist die verkettete Spannung zwischen diesen ungleich Null. Die Höhe dieser verketteten Spannung ist in bekannter Weise abhängig von der Phasendifferenz zwischen den Spannungsanzeigesignalen sowie von der Amplitude der Spannungsanzeigesignale 8, 9.

Der Phasendifferenzdetektor 14 weist einen Schwellwertdetektor auf, der in dieser Ausführungsform zwei antiseriell geschaltete Zenerdioden 27a, 27b umfasst. Weiterhin umfasst der Phasendifferenzdetektor 14 eine erste und eine zweite Impedanz 28a, 28b, über welche dem Phasendifferenzdetektor 14 die Spannungsanzeigesignale 8, 9 zugeleitet werden. Der Phasendifferenzdetektor 14 ist bevorzugt symmetrisch zu seinen Eingängen aufgebaut, d. h. in einem Eingang des Phasendifferenzdetektors 14 ist eine erste Impedanz 28a in Reihe mit einer ersten Zenerdiode 27a, entsprechend in dem anderen Eingang des Phasendifferenzdetektors 14 sind eine Impedanz 28b in Reihe mit einer Zenerdiode 27b angeordnet. Ist nur eines der Spannungsanzeigesignale 8 oder 9 gleich Null, so ergibt sich ein Phasendifferenzsignal 4, welches typischerweise größer als die Durchbruchspannung der Zenerdioden ist, und es wird das Symbol für eine Phasendifferenz auf dem Phasendifferenzanzeigeelement 15 angezeigt.

Übersteigt die Spannung zwischen den Spannungsanzeigesignalen 8, 9 der Höhe nach die Schwellwertspannung, welche durch die Zenerdioden 27a, 27b eingestellt ist, so wird durch das Phasendifferenzsignal 4 das Phasendifferenzanzeigeelement 15 angesteuert, sodass das Phasendifferenzanzeigeelement 15 dementsprechend ein Symbol anzeigt, beispielsweise ein ≠. Das Phasendifferenzanzeigeelement 15 ist dabei vorzugsweise eine passive Anzeige, vorzugsweise eine LCD-Anzeige, welche lediglich das Phasendifferenzsignal 4 zur Ansteuerung der Anzeige benötigt, darüber hinaus jedoch keine Betriebsspannungsversorgung.

Das erste Spannungsanzeigeelement 12 sowie das zweite Spannungsanzeigeelement 13 und das Phasendifferenzanzeigeelement 15 können in einer Ausführungsform in einem gemeinsamen LCD-Panel 5 angeordnet sein.

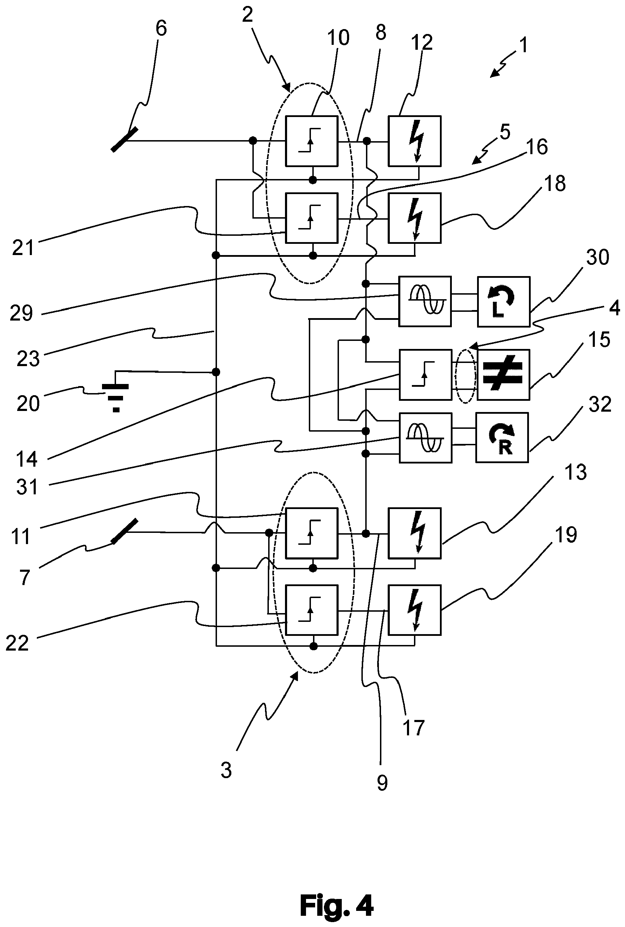

Figur 4 zeigt eine weitere Ausführungsform einer Phasenvergleicherschaltung, welche alle Elemente der in Fig. 1 gezeigten Anordnung umfasst. Der erste Messkanal 2 umfasst zusätzlich einen dritten Spannungsdetektor 21, der ebenso wie der erste Spannungsdetektor 10 mit dem ersten Leiter 6 verbunden ist und ein Spannungsanzeigesignal erzeugt, hier ein drittes Spannungsanzeigesignal 16. Das dritte Spannungsanzeigesignal steuert ein drittes Spannungsanzeigeelement 18 an. Idealerweise zeigt das dritte Anzeigeelement damit das gleiche an wie das erste Anzeigeelement 12.

Ebenso umfasst zweite Messkanal 3 umfasst einen weiteren vierten Spannungsdetektor 22, der ebenso wie der zweite Spannungsdetektor 11 mit dem zweiten Leiter 7 verbunden ist und der ein viertes Spannungsanzeigesignal 17 erzeugt. Das vierte Spannungsanzeigesignal 17 steuert ein viertes Spannungsanzeigeelement 19 an.

Die Prüfung auf Spannung wird somit in jedem Messkanal redundant durchgeführt und angezeigt, sodass bei divergierenden Anzeigen zwischen dem ersten und dritten beziehungsweise dem zweiten und vierten Spannungsanzeigeelement der Benutzer einen Warnhinweis erhält.

Weiterhin umfasst die Phasenvergleicherschaltung 1 einen an sich bekannten passiven ersten Drehfeldrichtungsdetektor 29 zur Ermittlung der Drehrichtung nach links, dessen Ausgang mit einer passiven Drehrichtungsanzeige 31 verbunden ist. Diese zeigt ein entsprechendes Symbol "Drehrichtung links" an, falls der Drehfeldrichtungsdetektor 29 die Drehrichtung links ermittelt. Ebenso umfasst die Phasenvergleicherschaltung 1 einen weiteren passiven Drehfeldrichtungsdetektor 31 zur Ermittlung der Drehrichtung nach rechts, dessen Ausgang mit einer zweiten passiven Drehrichtungsanzeige 32 verbunden ist, und die ein entsprechendes Symbol "Drehrichtung rechts" anzeigt, falls der passive Drehfeldrichtungsdetektor rechts 31 dies ermittelt. Beide Drehrichtungsanzeiger 29, 31 erhalten als Eingänge jeweils das erste und zweite Spannungsanzeigesignal 8 - 9, anhand derer sie die Richtung des Drehfelds ermitteln und ein entsprechendes Steuersignal an die jeweilige passive Drehrichtungsanzeige 30, 32 ausgeben, sodass ein entsprechendes Symbol von der jeweiligen Drehrichtungsanzeige angezeigt wird. Die Drehfeldrichtungsanzeiger 29, 31 sind bevorzugt identisch baugleich, sodass die jeweilige Rückwirkung auf die

### Bezugszeichenliste

- 1: Phasenvergleicherschaltung
- 2: erster Messkanal
- 3: zweiter Messkanal
- 4: Phasendifferenzsignal
- 5: gemeinsames Anzeigeelement
- 6: erster Leiter
- 7: zweiter Leiter
- 8: erstes Spannungsanzeigesignal
- 9: zweites Spannungsanzeigesignal
- 10: erster Spannungsdetektor
- 11: zweiter Spannungsdetektor
- 12: erstes Spannungsanzeigeelement
- 13: zweites Spannungsanzeigeelement
- 14: Phasendifferenzdetektor
- 15: Phasendifferenzanzeigeelement
- 16: drittes Spannungsanzeigesignal
- 17: viertes Spannungsanzeigesignal
- 18: drittes Spannungsanzeigeelement
- 19: viertes Spannungsanzeigeelement
- 20: Bezugspotential (Erdpotential)
- 21: dritter Spannungsdetektor
- 22: vierter Spannungsdetektor
- 23: Erdleiter
- 24: antiseriell geschaltete Zenerdioden
- 25: Impedanz
- 26: Leitung
- 27a, 27b: Zenerdiode
- 28a, 28b: Impedanz
- 29: passiver Drehfeldrichtungsdetektor links
- 30: passive Drehrichtungsanzeige links
- 31: passiver Drehfeldrichtungsdetektor rechts
- 32: passive Drehrichtungsanzeige rechts

## Patentansprüche

1. Phasenvergleicherschaltung (1) mit einem ersten passiven und einem zweiten passiven Messkanal (2, 3) und jeweiligen passiven Spannungsanzeigeelementen (12, 13) zur Ermittlung und Anzeige einer Spannungsfreiheit eines ersten und eines zweiten Leiters (6, 7) und mit einem passiven Phasendifferenzdetektor (4) sowie einem passiven Phasendifferenzanzeigeelement zur Anzeige einer Phasendifferenz zwischen elektrischen Messspannungen der Leiter (6, 7),
wobei der erste Leiter (6) mit einem Eingang des ersten Messkanals (2) der Schaltung (1) und der zweite Leiter (7) mit einem Eingang eines zweiten Messkanals (3) der Schaltung (1) verbunden ist, und
wobei der erste Messkanal (1) zur Erzeugung eines ersten Spannungsanzeigesignals (8) einen passiven Spannungsdetektor (10) aufweist und mit einem ersten Spannungsanzeigeelement (12) verbunden ist, und
wobei der zweite Messkanal (3) zur Erzeugung eines zweiten Spannungsanzeigesignals (9) einen passiven Spannungsdetektor (11) aufweist und mit einem zweiten Spannungsanzeigeelement (13) verbunden ist, und
wobei der jeweilige Ausgang des ersten und des zweiten Spannungsdetektors (10, 11) mit jeweiligen Eingängen des Phasendifferenzdetektors (14) zur Erzeugung eines Phasendifferenzsignals (4) verbunden ist, und
ein Ausgang des Phasendifferenzdetektors (14) mit dem passiven Phasendifferenzanzeigeelement (15) zur Anzeige einer Phasendifferenz verbunden ist.

2. Phasenvergleicherschaltung nach Anspruch 1, wobei das passive erste und zweite Spannungsanzeigeelement (12, 13) und das Phasenvergleichsanzeigeelement (15) jeweils eine passive LCD- Anzeige ist.

3. Phasenvergleicherschaltung nach einem der vorstehenden Ansprüche, wobei das erste und das zweite Spannungsanzeigeelement und das Phasendifferenzanzeigeelement in einer gemeinsamen LCD-Anzeige angeordnet sind.

4. Phasenvergleicherschaltung (1) nach einem der vorstehenden Ansprüche, wobei mindestens eines der Spannungsanzeigeelemente (10, 11) oder das Phasendifferenzanzeigeelement (15) eine lichtreflektierende Schicht aufweist.

5. Phasenvergleicherschaltung (1) nach einem der vorstehenden Ansprüche, wobei der Spannungsdetektor (10) zwei antiseriell geschaltete Zenerdioden (24) umfasst.

6. Phasenvergleicherschaltung (1) nach einem der vorstehenden Ansprüche, wobei ein Messkanal (2, 3) eine Impedanz (25) aufweist.

7. Phasenvergleicherschaltung (1) nach Anspruch 6, wobei die Impedanz (25) eine Kapazitanz ist.

8. Phasenvergleicherschaltung (1) nach einem der vorstehenden Ansprüche, wobei der Phasendifferenzdetektor (14) einen Spannungsdetektor aufweist.

9. Phasenvergleicherschaltung nach Anspruch 8, wobei der Phasenvergleicher zwei Zenerdioden umfasst, und wobei das Phasendifferenzanzeigeelement (15) zwischen den beiden Zenerdioden (27a, 27b) angeordnet ist.

10. Phasenvergleicherschaltung (1) nach einem der vorstehenden Ansprüche, wobei ein Messkanal (2, 3) einen weiteren Spannungsdetektor (10, 11, 21, 22) aufweist, wobei ein jeder Spannungsdetektor (10, 11, 21, 22) mit einem jeweiligen Spannungsanzeigeelement (12, 13, 18, 19) verbunden ist.

11. Phasenvergleicherschaltung (1) nach einem der vorstehenden Ansprüche, wobei der erste passive Messkanal (2) und der zweite passive Messkanal (3) die gleichen elektrischen Bauelemente aufweisen.

12. Phasenvergleicherschaltung (1) nach einem der vorstehenden Ansprüche, umfassend einen passiven Drehfeldrichtungsdetektor (29, 31), und eine damit verbundene passive Drehfeldrichtungsanzeige (30, 32).

13. Phasenvergleicherschaltung (1) nach Anspruch 12,, wobei der Drehfeldrichtungsdetektor mit dem ersten und zweiten Spannungsanzeigesignal (8, 9)) verbunden ist.

14. Phasenvergleicherschaltung (1) nach einem der vorstehenden Ansprüche, wobei der zugehörige Phasenvergleicher in Versorgungsnetzen eingesetzt wird, in denen die Leiter-Erde-Spannung mehr als 1000 Volt beträgt.
